Europäisches Patentamt

European Patent Office

Office européen des brevets

(19)

(11) Veröffentlichungsnummer : **0 428 663 B1**

(12) # EUROPÄISCHE PATENTSCHRIFT

(45) Veröffentlichungstag der Patentschrift :
**11.08.93 Patentblatt 93/32**

(21) Anmeldenummer : **90908190.3**

(22) Anmeldetag : **28.05.90**

(86) Internationale Anmeldenummer :
**PCT/DE90/00391**

(87) Internationale Veröffentlichungsnummer :
**WO 90/15340 13.12.90 Gazette 90/28**

(51) Int. Cl.⁵ : **G01R 31/28,** G01R 31/305

---

(54) **VERFAHREN UND ANORDNUNG ZUR SCHNELLEN SPEKTRUMANALYSE EINES SIGNALS AN EINEM ODER MEHREREN MESSPUNKTEN.**

---

(30) Priorität : **29.05.89 DE 3917411**

(43) Veröffentlichungstag der Anmeldung :
**29.05.91 Patentblatt 91/22**

(45) Bekanntmachung des Hinweises auf die
Patenterteilung :
**11.08.93 Patentblatt 93/32**

(84) Benannte Vertragsstaaten :
**AT BE CH DE DK ES FR GB IT LI LU NL SE**

(56) Entgegenhaltungen :
**US-A- 4 220 853**
**US-A- 4 223 220**

(56) Entgegenhaltungen :
**JOURNAL OF PHYSICS E. SCIENTIFIC IN-
STRUMENTS, vol. 21, 1988, ISHING, BRISTOL,
GB, pages 913-915, K. Nakamae et al.:
"Accurate measurement of the operating frequency in ICs with the SEM"
ELECTRONICS, vol. 59, No. 12, March 1986,
New York, US, pages 51-54; "Electron-beam
testing of VLSI chips gets practical"
MICROELECTRONIC ENGINEERING, vol. 4,
1986, Amsterdam NL, pages 77-106, E. Wolfgang: "Electron beam testing"**

(73) Patentinhaber : **Brust, Hans-Detlef
Martin-Luther-Strasse 2
W-6602 Dudweiler (DE)**

(72) Erfinder : **Brust, Hans-Detlef
Martin-Luther-Strasse 2
W-6602 Dudweiler (DE)**

(74) Vertreter : **Münich, Wilhelm, Dr. et al
Kanzlei Münich, Steinmann, Schiller
Wilhelm-Mayr-Str. 11
W-8000 München 21 (DE)**

EP 0 428 663 B1

---

EP 0 428 663 B1

## Beschreibung

## Technisches Gebiet

Die Erfindung betrifft ein Verfahren zur Durchführung einer schnellen Spektrumanalyse eines Signals an einem oder mehreren Meßpunkten und zur Ermittlung der örtlichen Verteilung einzelner Spektrallinien sowie eine Anordnung zur Durchführung des Verfahrens.

## Stand der Technik

Die Überprüfung der Funktionsweise hochintegrierter Schaltungen erfolgt üblicherweise in rechnergesteuerten Testsystemen, in denen die vorhandenen Fehler durch Analyse der an den Ausgängen der untersuchten Schaltung in Abhängigkeit von den jeweils eingespeisten Bitmustern gemessenen Spannungspegel zwar erkannt, aber nur sehr schwer lokalisiert werden können. Deshalb müssen insbesondere während der Entwicklungsphase zusätzliche Messungen im Innern hochintegrierter Schaltungen durchgeführt werden.

Als für diese Zwecke besonders geeignet, haben sich die in allen Bereichen der Entwicklung und Fertigung mikroelektronischer Bauelemente eingesetzten Korpuskularstrahl-Meßverfahren und hier wieder besonders die Elektronenstrahl-Meßtechnik herausgestellt. Mit Hilfe dieser Meßtechniken läßt sich beispielsweise die elektrische Potentialverteilung in integrierten Schaltungen abbilden (hier sind insbesondere die dem Fachmann unter der Bezeichnung "Voltage Coding" bzw. "Logic-State Mapping" bekannten Verfahren zu nennen) oder der zeitliche Potentialverlauf an einem einzelnen Knotenpunkt bestimmen ("Waveform-Messung"). Eine Zusammenfassung der zur Zeit gewöhnlich eingesetzten Testverfahren der Elektronenstrahl-Meßtechnik ist in der Veröffentlichung "Electron Beam Testing" von E. Wolfgang (Zeitschrift "Microelectronic Engineering", Band 4, 1986, Seiten 77 -106) und der Veröffentlichung "Electron Beam Testing" von K. Ura und H. Fujioka (Zeitschrift "Advances in Electron-ics and Electron Physics", Band 73, 1989, Seiten 233 -317) wiedergegeben.

Eine wichtige Aufgabenstellung besteht dabei auch darin, festzustellen, ob an einer Leiterbahn ein Signal mit einer bestimmten Frequenz vorliegt oder nicht bzw. welches Frequenzspektrum das Signal am jeweiligen Meßpunkt aufweist. Eine weitere Aufgabe besteht dann darin, zu ermitteln, welche Leiterbahnen ein bestimmtes Signal (und damit eine bestimmte Signalfrequenz) führen. Zur Lösung dieser Aufgaben wurden das Frequency-Tracing- und das Frequency-Mapping-Verfahren entwickelt. Diese Verfahren sind ausführlich in der Veröffentlichung "Frequency Tracing and Mapping in Theory and Praxis" von H.-D. Brust und F. Fox (Zeitschrift "Microelectronic Engineering", Band 2, 1984, Seiten 299 - 323) beschrieben. Besonders nützlich sind diese Verfahren bei der Untersuchung asynchroner Schaltungen, da dort die übrigen Verfahren, die auf Samplingtechniken beruhen, mangels Synchronisation versagen.

Bei den bisherigen Realisierungen der Frequenzbereichsmethoden Frequency Tracing und Mapping läßt sich aus Gründen, die im folgenden noch erläutert werden, eine Spektrumanalyse leider nur recht langsam durchführen. Die zur Beschleunigung vorgeschlagenen Verfahren, die auf dem Prinzip der Geschwindigkeitmodulation beruhen, sind leider relativ aufwendig. Außerdem unterscheidet sich die Durchführung einer solchen Messung erheblich von den im Bereich der Hochfrequenztechnik üblichen Messungen, was einem mit der Elektronenstrahlmeßtechnik wenig vertrauten Benutzer Probleme bereitet.

## Darstellung der Erfindung

Der Erfindung liegt daher die Aufgabe zugrunde eine einfache und kostengünstige Möglichkeit zur schnellen Spektrumanalyse eines Signals bzw. zur Darstellung der örtlichen Verteilung der Spektrallinien bereitzustellen.

Diese Aufgabe wird erfindungsgemäß durch ein Verfahren nach Anspruch 1 und eine Anordnung nach Anspruch 7 gelöst. Ausgestaltungen und Vorteile der Erfindung sind in den Unteransprüchen, der Beschreibung und den Zeichnungen dargestellt.

Der mit der Erfindung erzielbare Vorteil liegt vor allem in der schnellen und dadurch für die untersuchte Probe schonenden Messung. Die schnelle Messung ermöglicht im Gegensatz zu den Verfahren nach dem Stand der Technik auch eine kontinuierliche Überwachung eines Signals an einem Meßpunkt. Darüberhinaus kann die Bedienung des Meßverfahrens bzw. der zugehörigen Anordnung genauso wie die entsprechenden Messungen in der herkömmlichen Hochfrequenzmeßtechnik erfolgen. Lediglich die Interpretation der erhaltenen Meßergebnisse unterscheidet sich geringfügig. Damit entfällt für den Benutzer die Einarbeitungszeit.

Während die Ansprüche 2 bis 6 bevorzugte Weiterbildungen des Verfahrens nach Anspruch 1 betreffen, sind die Ansprüche 8 bis 14 auf Ausgestaltungen der Vorrichtung zur Durchführung des Verfahrens gerichtet.

2

EP 0 428 663 B1

**Kurze Beschreibung der Zeichnung**

Die Erfindung wird nachfolgend anhand der Zeichnungen näher erläutert. Dabei zeigen:

Fig. 1     das Grundprinzip der Frequenzbereichsmethoden,

Fig. 2     eine Anordnung zur Durchführung des herkömmlichen Frequency-Tracing Verfahrens,

Fig. 3     eine Anordnung zur Durchführung des herkömmlichen Frequency-Mapping-Verfahrens,

Fig. 4     eine Anordnung zur Durchführung des erfindungsgemäßen Verfahrens,

Fig. 5     die Erweiterung der Anordnung nach Fig. 4 zur Messung der räumlichen Verteilung einzelner Spektrallinien,

Fig. 6     ein Beispiel für ein Meßergebnis, wie es mit der Anordnung nach Fig. 4 oder 5 erhalten werden kann.

In den Figuren sind jeweils gleiche Signale bzw. Schaltungsteile mit den gleichen Bezugszeichen gekennzeichnet.

**Darstellung von Ausführungsbeispielen**

Obwohl sich die folgenden Ausführungsbeispiele auf ein Elektronenstrahl-Meßgerät beziehen, ist die Erfindung so zu verstehen, daß anstelle von Elektronen auch Ionen oder andere Korpuskel verwendet werden können und zwar sowohl als Primärkorpuskel als auch-als Sekundärkorpuskel. Ebenso ist es möglich, daß anstelle der Primär- bzw. Sekundärkorpuskeln eine Strahlung, wie z.B. Laser- oder Röntgenstrahlung tritt.

Bei den Meßverfahren der Elektronenstrahlmeßtechnik richtet man einen fein fokussierten Primärelektronenstrahl auf die zu untersuchende Meßstelle der integrierten Schaltung. Die dort auftreffenden Primärelektronen lösen aus der Probenoberfläche Sekundärelektronen aus, die durch die elektrischen Potentiale auf der Probenoberfläche beeinflußt werden. Diese Beeinflussung äußert sich in einem Sekundärelektronenstrom, der vom Potential am Meßort abhängt, bzw. in einer Energieverschiebung der Sekundärelektronen, die ebenfalls vom elektrischen Potential am Meßort bestimmt wird und mit Hilfe eines Energiespektrometers gemessen werden kann. Diesen Effekt bezeichnet man als Potentialkontrast.

Im Prinzip sollte es also genügen die Meßstelle mit Primärelektronen zu beaufschlagen, den entsprechenden Sekundärelektronenstrom zu registrieren und das Sekundärelektronen-Signal einem herkömmlichen Spektrumanalysator zuzuleiten und von diesem dann eine Spektrumanalyse durchführen zu lassen. Dies ist auch in der Tat möglich, allerdings nur bei relativ geringen Frequenzen des zu untersuchenden Signals. Der Grund dafür ist die Tatsache, daß die zur Registrierung der Sekundärelektronen erforderlichen Detektoren gewöhnlich nur eine relativ geringe Bandbreite von einigen MHz aufweisen. Daher muß auch bei den Zeitbereichsverfahren zur Erzielung einer hohen Zeitauflösung ein Abtastverfahren eingesetzt werden, bei dem der zeitliche Verlauf des Signals am Meßort ähnlich wie bei einem Sampling-Oszilloskop mit kurzen Elektronenimpulsen auf ein Triggersignal hin abgetastet wird.

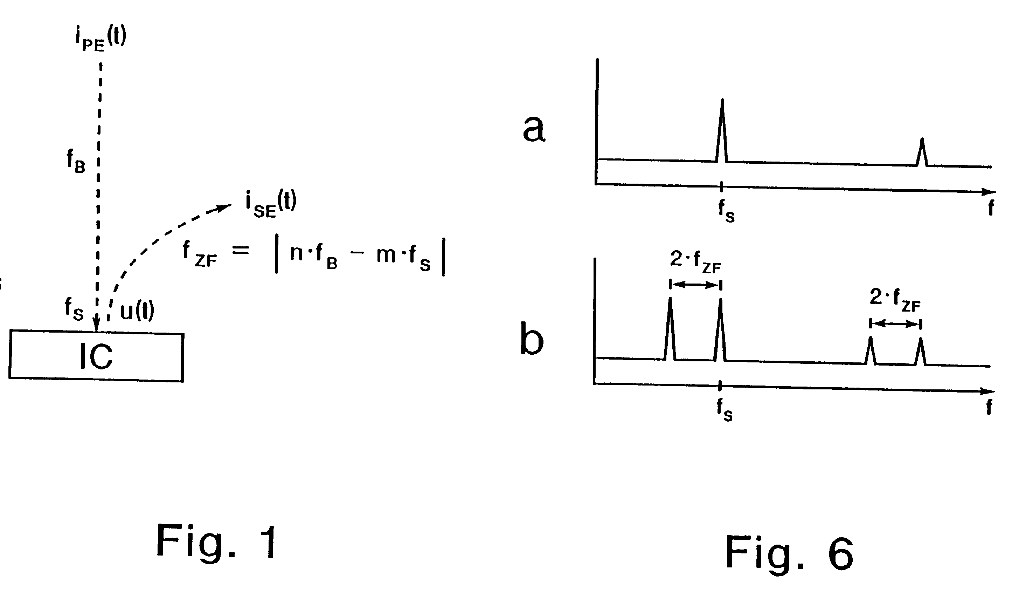

Bei den Frequenzbereichsverfahren "Frequency Tracing" und "Frequency Mapping" bedient man sich zur Überwindung dieser Schwierigkeit eines anderen Kunstgriffs, und zwar wird die im allgemeinen recht hohe zu untersuchende Signalfrequenz noch vor dem die Bandbreite begrenzenden Detektor auf eine niedrige, vom Sekundärelektronen-Detektor leicht zu übertragende Zwischenfrequenz heruntergemischt. Für diesen Mischvorgang bedient man sich dabei des Potentialkontrasts als nichtlinearer Wechselwirkung. Fig. 1 verdeutlicht dieses Prinzip. Der Potentialkontrast sorgt dafür, daß der Sekundärelektronenstrom $i_{SE}$ zum einen dem Primärelektronenstrom $i_{PE}$ proportional ist und zum anderen vom Signal u(t) am Meßort abhängt. Es gilt also die Beziehung

$$i_{SE(t)} \; = \; i_{PE}(t) \; * \; g(u(t)) \quad (1)$$

wobei g die Potentialkontrastkennlinie, also den Zusammenhang zwischen der Signal u(t) am Meßort und dessen Einfluß auf den Sekundärelektronenstrom $i_{SE}$, bezeichnet. In erster Näherung kann man diese Kennlinie als linear und damit die Beziehung (1) als rein multiplikativen Zusammenhang ansehen. Hat nun das Signal u(t) in seinem Spektrum eine Signalfrequenz $f_S$ so kann diese auf die niedrige Zwischenfrequenz $f_{ZF}$ gemischt werden, indem man den Primärelektronenstrahl PE und damit auch den Primärelektronenstrom $i_{PE}(t)$ mit einer Frequenz $f_B$, die geringfügig, nämlich genau um $f_{ZF}$, gegen die zu messende Signalfrequenz $f_S$ verschoben ist, moduliert. Genauer gesagt, muß die Mischbedingung

$$| \, n \, f_B \, - \, m \, f_S \, | \; = \; f_{ZF} \quad (2)$$

erfüllt werden. Für die folgenden Überlegungen wird dabei ohne Beschränkung der Allgemeinheit jeweils eine Grundwellenmischung, also der Fall n=m=1 zugrundegelegt. Die Oberwellenmmischung erfolgt analog, lediglich muß dann in den späteren Beziehungen jeweils $f_B$ durch $n f_B$ bzw. $f_S$ durch $m f_S$ ersetzt werden.

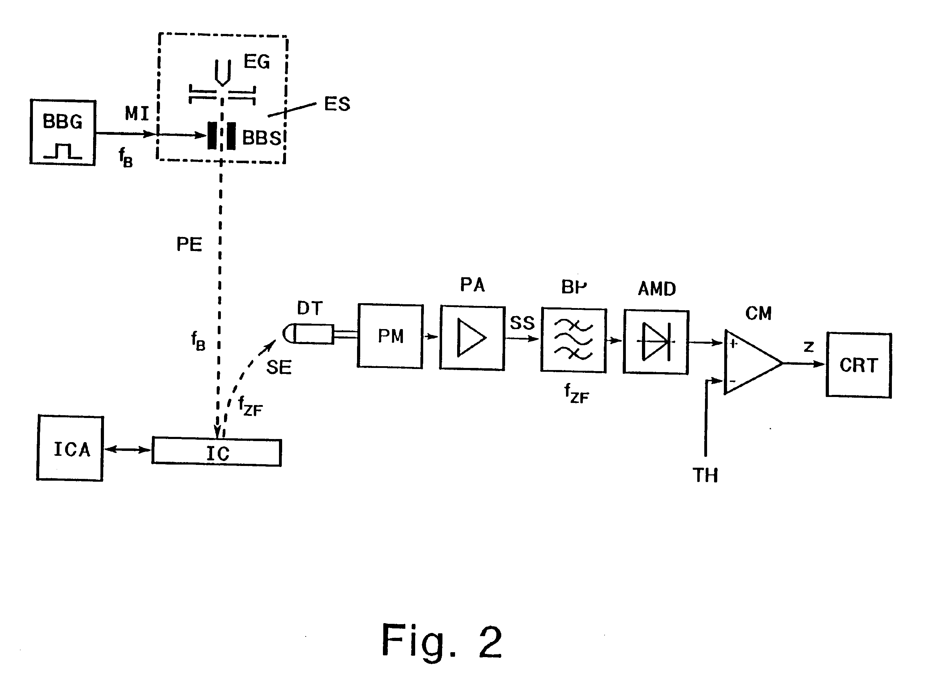

Fig. 2 zeigt, wie dieses Grundprinzip beim Frequency-Tracing-Verfahren verwirklicht wird. Mit dem FrequencyTracing-Verfahren kann die örtliche Verteilung einzelner Spektrallinien bestimmt werden, d.h. es werden alle Meßpunkte abgebildet, die ein Signal mit einer bestimmten Frequenz im Signalspektrum führen.

3

Fig. 2 zeigt schematisch eine Anordnung, mit der das Frequency-Tracing-Verfahren realisiert werden kann. Das Kernstück dieser wie auch der später beschriebenen Anordnungen bildet ein beispielsweise aus den US-Patentschriften 4220853 und 4223220 bekanntes Elektronenstrahl-Meßgerät bzw. ein Raster-Elektronenmikroskop. In der elektronenoptischen Säule eines solchen Elektronenstrahl-Meßgerätes wird ein fein gebündelter Primärelektronenstrahl PE erzeugt. Diese elektronenoptische Säule weist neben einer Vielzahl in der Fig. 2 und den späteren Figuren aus Gründen der Übersichtlichkeit nicht dargestellten Blenden und elektrischen oder magnetischen Linsensystemen zur Strahlformung, Strahlablenkung und zur Strahlfokussierung eine Elektronenquelle ES, die den Primärelektronenstrahl PE erzeugt, auf.

Die Elektronenquelle ES hat die Aufgabe, den mit der Frequenz fB modulierten Primärelektronenstrahl zu generieren. In Fig. 2 ist sie aus einer im wesentlichen aus einer Kathode, die die Primärelektronen durch thermische Emission erzeugt, einer Anode und einer Wehnelt-Elektrode bestehenden Elektronenkanone EG und einem Strahlmodulations- oder -austastsystem BBS aufgebaut. Mit Hilfe des Strahlmodulationssystems BBS wird der von der Kathode gelieferte kontinuierliche Primärelektronenstrom in seiner Intensität moduliert. Auf diese Weise kann ein Primärelektronenstrom mit der Frequenz $f_B$ erzeugt werden. Mögliche Ausführungsformen von Elektronenkanone EG und Strahlmodulationssystem BBS sind beispielsweise in der Veröffentlichung "Electron beam chopping systems in the SEM" von E. Menzel und E. Kubalek (Scanning Electron Microscopy, SEM Inc., AMF O'Hare, 1979/I, Seiten 305-317) beschrieben. Ein geeignetes Strahlmodulationssystem ist beispielsweise aus der US-Patentschrift 4 169 229 bekannt.

Zur Erzeugung des modulierten Primärelektronenstroms ist ein Strahlmodulationsgenerator BBG mit dem Modulationseingang MI der Elektronenquelle ES verbunden. Der Strahlmodulationsgenerator BBG steuert das Strahlmodulationssystem BBS mit einem Modulationssignal MS an. In dieser Realisierung besteht das Modulationssignal MS aus Rechteckimpulsen, die mit konstanter Wiederholfrequenz $f_B$ auftreten. Andere Möglichkeiten zur Ansteuerung des Strahlmodulationssystems mit unterschiedlichen Signalformen sind ebenfalls in der zitierten Veröffentlichung von E. Menzel und E. Kubalek beschrieben und könnten im Prinzip ebenfalls verwendet werden. Jeder Rechteckimpuls des Modulationssignals MS tastet den Primärelektronenstrahl PE kurz ein und erzeugt so einen Primärelektronenimpuls.

Die Breite der Rechteckimpulse bestimmt dabei die Dauer der Primärelektronenimpulse. Im Gegensatz zu den Zeitbereichsmethoden wird der Strahlmodulationsgenerator BBS nicht mit der übrigen Meßanordnung synchronisiert.

Die so erzeugten Primärelektronenimpulse werden dann durch die in Fig. 2 nicht dargestellten Linsensysteme auf die Probe IC, beispielsweise eine integrierte Schaltung, fokussiert. Dort lösen die auftreffenden Primärelektronen PE Sekundärelektronen SE aus, die vom Detektor DT registriert und in Lichtimpulse umgewandelt werden. Diese Lichtimpulse werden dann über einen Lichtleiter zu dem gewöhnlich außerhalb der Probenkammer des Elektronenstrahlmeßgerätes befindlichen Photomultiplier PM geleitet, der die Lichtimpulse wieder in ein elektrisches Signal umsetzt, das dann, gegebenenfalls nach weiterer Verstärkung in einem dem Photomultiplier PM nachgeschalteten Vorverstärker PA, als (in diesem Fall elektrisches) sekundäres Signal SS zur weiteren Auswertung zur Verfügung steht.

Die zu untersuchende Probe IC wird zur Reproduktion des interessierenden Vorgangs, z.B. eines Fehlers, zyklisch betrieben. Dazu wird die Probe IC von einer Ansteuerung ICA mit Versorgungsspannungen und gegebenenfalls Eingangssignalen zur Stimulation versorgt. Als Ansteuerung ICA kann dabei insbesondere ein Funktionstester dienen.

Falls nun am Meßpunkt die Signalfrequenz $f_S$ auftritt, so erscheint im Sekundärelektronenstrom ein Signalanteil bei der Zwischenfrequenz $f_{ZF}$. Dieser Signalanteil wird mit Hilfe eines auf die Zwischenfrequenz $f_{ZF}$ fest abgestimmten Bandpaßfilters BP ausgefiltert, in einem Hüllkurvendemodulator AMD demoduliert und sodann, gegebenenfalls nach Vergleich mit einem Schwellwert TH in einem Komparator CM dem z-Eingang des Bildschirms CRT des Elektronenstrahlmeßgerätes zugeführt und bewirkt damit eine Helligkeitsmodulation des Schreibstrahls des Bildschirms. Rastert man nun den Primärelektronenstrahl PE über die Probe -dies kann durch eine entsprechende Ansteuerung der Ablenkspulen des Elektronenstrahlmeßgerätes geschehen -und wird wie üblich auch der Schreibstrahl der Bildröhre CRT synchron dazu bewegt, so ergibt sich auf dem Bildschirm eine Helligkeitsverteilung, die der örtlichen Verteilung der durch die spezielle Wahl der Modulationsfrequenz $f_B$ über die Mischbedingung (2) ausgewählten Signalfrequenz $f_S$ auf dem abgerasterten Probenbereich entspricht.

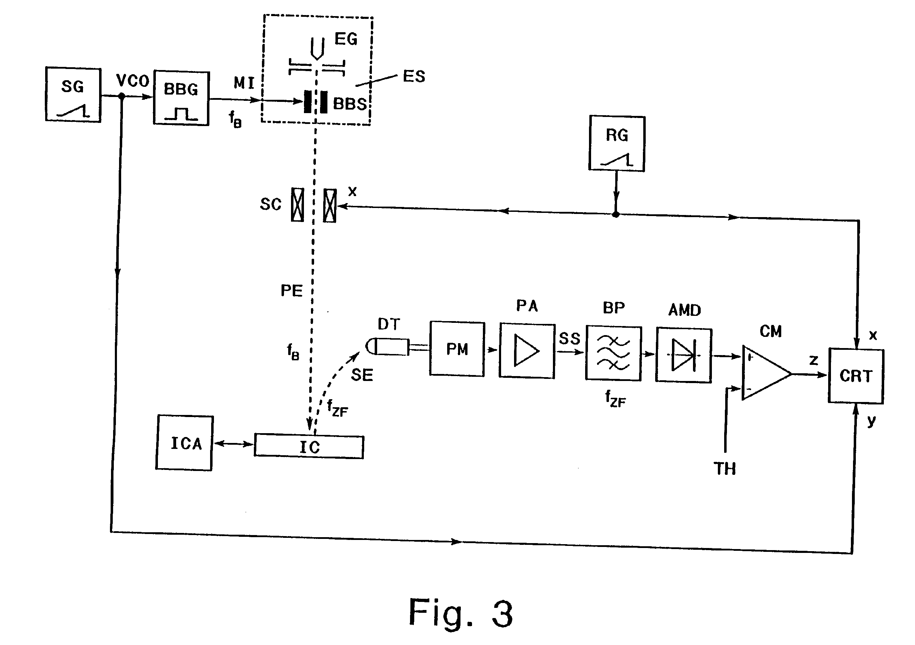

Will man nun das Spektrum eines Signals an einem Meßpunkt bestimmen, so genügt es, die Modulationsfrequenz über den interessierenden Frequenzbereich durchzuwobbeln. Dies geschieht beim sogenannten Frequency-Mapping-Verfahren. Eine Anordnung zur Realisierung dieses Verfahrens zeigt Fig. 3. Sie unterscheidet sich nur unwesentlich von der Anordnung nach Fig. 2. Lediglich ist jetzt der Strahlmodulationsgenerator BBG als spannungssteuerbarer Oszillator (also als VCO) ausgelegt und wirt von von einem Rampengenerator SG mit einer Steuerspannung, die die Ausgangsfrequenz $f_B$ bestimmt, versorgt. Mit dieser Steuerpannung wird nun zugleich die y-Ablenkung des Schreibstrahls der Bildröhre beaufschlagt, während die x-Anblenkung weiterhin vom Ablenkgenerator RG, der auch den Primärelektronenstrahl bewegt, gesteuert wird. Der Primärelektronenstrahl wird bei diesem Meßverfahren nur in einer Richtung entlang einer Linie abgelenkt. Durch die rampenförmige Steuerspannung wird die Modulationsfrequenz $f_B$ über den interessierenden Frequenzbereich gewobbelt. Da zugleich der Primärelektronenstrahl bewegt wird, erfolgt auf diese Weise eine Spektrumanalyse der Signale an einer ganzen Linie von Meßpunkten. Die Höhe der Spektrallinien wird dabei durch die Helligkeit der entsprechenden Stellen auf dem Bildschirm CRT angezeigt.

Gewöhnlich wird der Strahlmodulationsgenerator beim Frequency-Tracing- und Frequency-Mapping-Verfahren als Frequenzsynthesizer realisiert. Leider weisen Synthesizer bei der Umschaltung von einer Frequenz auf den nächsten Frequenzwert, wie dies beim Durchwobbeln der Modulationsfrequenz erforderlich ist, relativ lange Schalt- und Einschwingzeiten auf, so daß das Durchwobbeln der Modulationsfrequenz $f_B$ nur relativ langsam erfolgen kann. In gewisser Weise macht man beim Frequency-Mapping-Verfahren aus dieser Not eine Tugend, indem pro Frequenzschritt nicht nur das Signal an einem einzelnen Meßpunkt sondern an einer ganzen Reihe von Meßorten entlang einer Linie analysiert wird. Außerdem ist die Ablesegenauigkeit beim Ablesen der Meßwerte vom Bildschirm des Elektronenstrahlmeßgerätes relativ gering.

Diese Probleme vermeidet das erfindungsgemäße Verfahren. Es basiert ebenfalls auf dem Grundprinzip der anderen Frequenzbereichsmethoden, also der Mischung der relativ hohen Signalfrequenz fS auf eine niedrige, vom Detektor leicht zu übertragende Zwischenfrequenz fZF. Die Grundidee des Verfahrens besteht darin, einen herkömmlichen dem Fachmann aus der Hochfrequenzmeßtechnik bekannten gewobbelten Spektrumanalysator (z.B. das Modell 2756 P von Tektronix; Aufbau und Wirkungswiese derartiger Spektrumanalysatoren ist dem Fachmann bekannt und wird z.B. in den Firmenschriften "Messungen mit dem Spektrumanalysator" von Hewlett-Packard bzw. "Grundlagen der Spektrumanalyse mit dem Spektrum Analyzer FSA" von Rohde & Schwarz beschrieben) zur eigentlichen Spektrumanalyse zu benutzen und dazu den Spektrumanalysator mit einer speziellen erfindungsgemäßen Anordnung mit dem Elektronenstrahlmeßgerät zu verbinden. Dies ist nicht nur vorteilhaft, weil ein Spektrumanalysator intern über einen schnellen Wobbelgenerator verfügt sondern ebenfalls weil die Detektionsschaltungen eines Spektrumanalysators im allgemeinen einschwingoptimiert sind und damit besonders kurze Reaktionszeiten aufweisen.

Die meisten Spektrumanalysatoren arbeiten nach einem Überlagerungsprinzip. Im Gegensatz zu den Frequenzbereichsmethoden der Elektronenstrahlmeßtechnik wird aber das Eingangssignal zur Vermeidung von Mehrdeutigkeiten durch Spiegelfrequenzen auf eine höhere interne Zwischenfrequenz f' gemischt und das Eingangssignal durch ein Tiefpaßfilter in seiner Bandbreite begrenzt. Beim Modell 2756 P von Tektronix liegt diese erste Zwischenfrequenz bei 2072 MHz, solange man im Grundband arbeitet und nur Signale bis 1,8 GHz analysieren möchte. Der Lokaloszillator, der den Eingangsmischer des Spektrumanalysators ansteuert, muß dann in seiner Frequenz $f_{LO}$ zwischen 2072 und 3872 MHz variieren. Diese Lokaloszillatorfrequenz $f_{LO}$ oder eine der späteren Stufen des Analysators ist im allgemeinen an einem Ausgang des Spektrumanalysators verfügbar. Dies gilt insbesondere dann, wenn der Spektrumanalysator für den Anschluß eines externen Mischers vorbereitet ist. In diesem Fall kann an dem Ausgang zum Anschluß des externen Mischers eine Lokaloszillatorfrequenz abgegriffen werden.

Nach dem erfindungsgemäßen Verfahren wird nun die Lokaloszillatorfrequenz $f_{LO}$ nach einer Frequenzkonversion zur Modulation des Primärelektronenstrahles benutzt. Die Frequenzkonversion ist erforderlich, da die Lokaloszillatorfrequenz wegen der im Spektrumanalysator verwendeten Aufwärtsmischung gewöhnlich nicht im gewünschten Bereich liegt. Meist ist sie viel zu hoch liegt. Will man im grundband des Spektrumanalysators arbeiten muß die Lokaloszillatorfrequenz um die interne Zwischenfrequenz f' minus die gewünschte Zwischenfrequenz $f_{ZF}$ reduziert werden. Für die Modulationsfrequenz $f_B$ gilt dann also:

$$f_B = f_{LO} - f' + f_{ZF} \quad (3)$$

Der Wert der Zwischenfrequenz $f_{ZF}$ ist prinzipiell beliebig. Sie muß nur so niedrig sein, daß sie problemlos vom Detektor übertragen werden kann, und sollte in einem Bereich liegen in dem möglichst wenig Störsignale und Rauschen auftreten. Bei den üblicherweise verwendeten Sekundärelektronen-Detektoren liegt der sinnvolle Frequenzbereich für die Zwischenfrequenz $f_{ZF}$ zwischen 250 kHz und 3 MHz. Führt man also eine Frequenzkonversion nach der Beziehung (3) durch, so werden gerade die Spektralanteile des zu untersuchenden Signals mit der Signalfrequenz

$$f_S = f_{LO} - f' \quad (4)$$

sowie natürlich auch die zugehörige Spiegelfrequenz

$$f'_S = f_{LO} - f' + 2 * f_{ZF} \quad (5)$$

durch den Potentialkontrast in die Zwischenfrequenzebene $f_{ZF}$ gemischt. Legt man wieder das Beispiel des Tektronix-Analysators 2756 P zugrunde und wählt man eine Zwischen-frequenz $f_{ZF}$ = 1 MHz, so variiert die Modulationsfrequenz zwischen 1 MHz und 1801 MHz, wenn der Spektrumanalysator das Grundband überstreicht. Entsprechend werden beim Überstreichen des gesamten Grundbandes die Spektralanteile des zu untersuchenden Signals u(t) am Meßort zwischen 0 MHz und 1800 MHz bzw. zwischen 2 MHz und 1802 MHz durch den Potentialkontrast in die konstante Zwischenfrequenzebene bei $f_{ZF}$ gemischt.

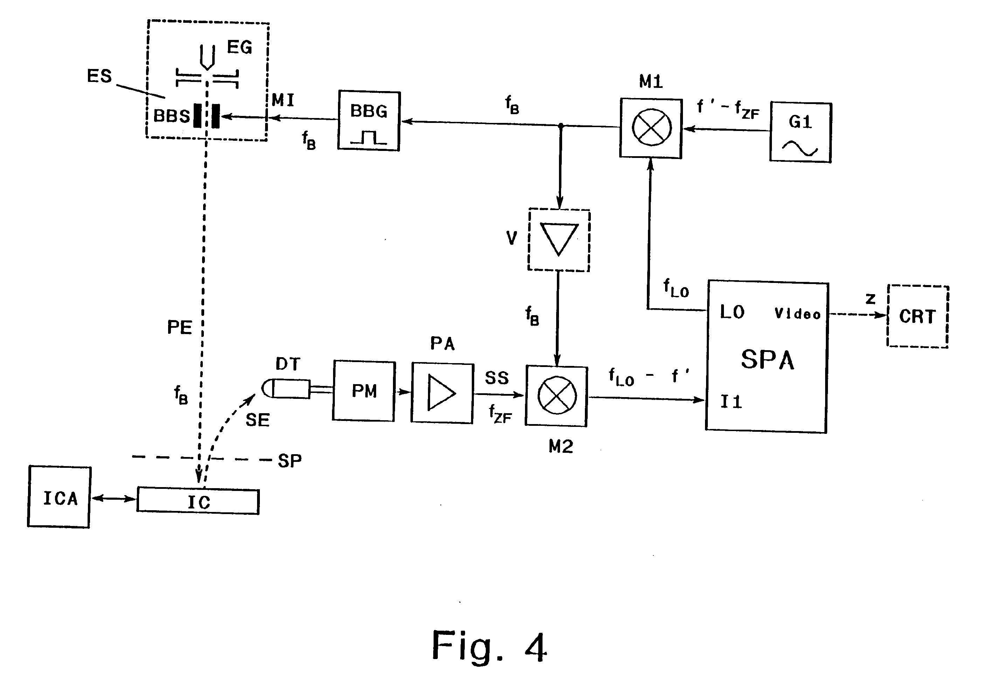

Wie dies realisiert werden kann zeigt die in Fig. 4 dargestellte erfindungsgemäße Anordnung. Dabei unterscheiden sich Probe, Probenansteuerung, Primärstrahlquelle ES und Detektionssystem DT zunächst nicht weiter von den schon in Fig. 2 und 3 dargestellten Anordnungen. Die Ausführungen zu diesen Komponenten, die bei den Anordnungen nach Fig. 2 und 3 dazu gemacht wurden, gelten in gleicher Weise auch für das erfindungsgemäße Verfahren. Die Gewinnung des Modulationssignals erfolgt allerdings anders als bei den Verfahren nach dem Stand der Technik. Dazu wird das Ausgangssignal LO des Lokaloszillators des Spektrumanalysator SPA mit der Frequenz $f_{LO}$ einem ersten Eingang eines Frequenzkonverters M1 - vorzugsweise einem Mischer - zugeführt. Dem zweiten Eingang des Frequenzkonverters wird ein Signal mit der Frequenz f' - $f_{ZF}$ zugeführt. Bei der Anordnung nach Fig. 4 wird dieses Signal von einem auf diese Frequenz festabgestimmten ersten Signalgenerator G1 erzeugt, dessen Ausgang mit dem zweiten Eingang des Frequenzkonverters verbunden ist. Statt mit einem festabgestimmten ersten Signalgenerator G1 kann das Signal der Frequenz f' - $f_{ZF}$ auch mit Hilfe einer PLL-Schaltung aus einer Ausgangsfrequenz des Spektrumanalysators - vorzugsweise aus der Referenzfrequenz - gewonnen werden. Der Aufbau derartiger PLL-Schaltungen ist dem Fachmann bekannt.

Das Ausgangssignal des Frequenzkonverters MI, der an seinem Ausgang die Differenzfrequenz seiner beiden Eingangsfrequenzen liefert, wird gegebenfalls nach einer Verstärkung in einem nachgeschalteten Verstärker zur Modulation des Primärelektronenstrahles benutzt. Dazu ist der Ausgang des Frequenzkonverters MI gegebenenfalls über den zwischengeschalteten Verstärker mit einem Eingang des Strahlmodulationsgenerators BBG verbunden. Dieser Generator macht aus dem sinusförmigen Ausgangssignal des Frequenzkonverters M2 ein rechteckförmiges Modulationssignal MS zur Ansteuerung des Strahlmodulationssystems BBS. Dazu sollte der Generator sinnvollerwise im "External Width"-Modus betrieben werden. Als Strahlmodulationsgenerator kann beispielsweise der Typ 8080 von Hewlett-Packard eingesetzt werden. Allerdings ist es auch möglich, das Strahlmodulationssystem BBS direkt mit dem sinusförmigen Ausgangssignal des Frequenzkonverters M1 bzw. des Verstärkers anzusteuern. In diesem Fall kann der Strahlmodulationsgenerator BBG entfallen bzw. durch ein passives "Bias-T" zur Überlagerung einer Gleichspannung zur optimalen Einstellung des Arbeitspunktes ersetzt werden.

Hinter dem Detektor DT und dem Vorverstärker PA liegt nun also die interessierende Spektralkomponente in der Zwischenfrequenzebene, also bei $f_{ZF}$, vor. Um nun die eigentliche Spektrumanalyse vom Spektrumanalysator SPA durchführen zu lassen, ist es erforderlich, dem Spektrumanalysator "vorzugaukeln", bei dieser Signalkomponente handele es sich um sein Eingangssignal. Dazu muß die Spektralkomponente von der Zwischenfrequenzebene in eine Eingangsfrequenzebene des Spektrumanalysators transformiert werden. Bei der Eingangsfrequenzeben kann es sich um die eigentliche variable Eingangsselektionsebene oder aber eine der gewöhnlich festen internen Zwischenfrequenzebenen des Spektrumanalysators handeln. Die erforderliche Frequenztransformation erfolgt wiederum mit Hilfe eines Frequenzkonverters.

Zunächst wird der Fall beschrieben, daß die Spektralkomponente in die Eingangsselektionsebene transformiert werden soll. Führt der Lokaloszillator die Frequenz $f_{LO}$, so wird am Eingang des Spektrumanalysators SPA gerade das Signal bei der Frequenz $f_{LO}$-f' analysiert. Dies ist die Eingangsselektionsebene, und da sie von der Lokaloszillatorfrequenz $f_{LO}$ abhängt, ist sie nicht konstant sondern variabel. Also muß die Frequenz der interessierenden Spektralkomponente von $f_{ZF}$ auf $f_{LO}$-f' erhöht werden. Dazu wird in Fig. 4 einem ersten Eingang eines zweiten Frequenzkonverters M2 das sekundäre Signal SS und damit auch die interessierende Signalkomponente bei $f_{ZF}$ zugeführt. Als Frequenzkonverter kann auch hier wieder ein Mischer eingesetzt werden. Wie man aus Gleichung (3) abliest, kann die gewünschte Frequenztransformation einfach dadurch erfolgen, daß man an den zweiten Eingang des Frequenzkonverters M2 die Modulationsfrequenz $f_B$ anlegt, denn am Ausgang eines Mischers, den man als Frequenzkonverter einsetzen kann, erscheinen die Summen- und die Differenzfrequenz seiner beiden Eingangssignale. Dazu ist der zweite Eingang des zweiten Frequenzkonverters M2 mit dem Ausgang des ersten Frequenzkonverters M1 gegebenenfalls über einen zwischengeschalteten Verstärker V verbunden. Am Ausgang des Frequenzkonverters steht dann die interessierende Spektralkomponente in der Eingangsselektionsebene des Spektrumanalysators an, so daß der Ausgang des Frequenzkonverters M2 einfach mit dem Selektionseingang I1 des Spektrumanalysators verbunden werden kann. Diese Beziehung bleibt unabhängig von der jeweils aktuellen Frequenz des Lokaloszillators $f_{LO}$ erhalten, so daß der Spektrumanalysator immer die Amplituden der gerade aktuellen Spektralkomponenten des zu untersuchenden Signals registriert.

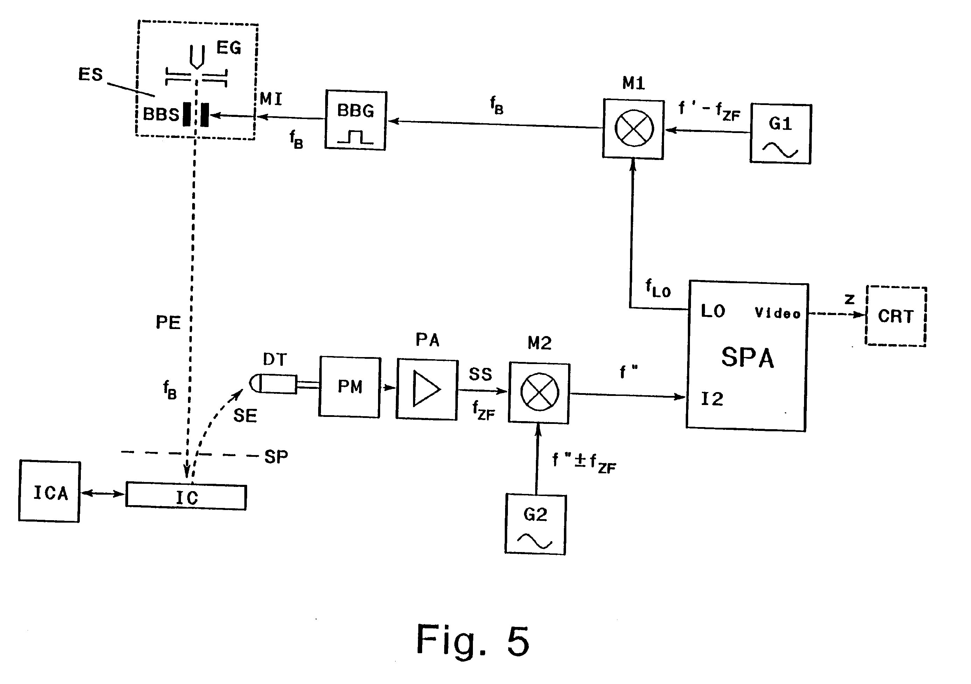

Fig. 5 zeigt eine Abwandlung der erfindungsgemäßen Anordnung, bei der die interessierende Spektralkomponente von der Zwischenfrequenzebene bei $f_{ZF}$ in eine interne Zwischenfrequenzbene des Spektrumanalysators SPA transformiert wird. Sie unterscheidet sich lediglich in der Beschaltung des zweiten Frequenzkonverters M2 von der erfindungsgemäßen Anordnung nach Fig. 4. Ist f" die feste interne Zwischenfrequenzebene, die als Eingangsfrequenzebene benutzt wird, so muß dem zweiten Eingang des zweiten Frequenzkonverters M2 die Frequenz f"-$f_{ZF}$ oder die Frequenz f"+$f_{ZF}$ zugeführt werden. Diese Frequenz liefert ein zweiter Signalgenerator G2, dessen Ausgang dazu mit dem zweiten Eingang des zweiten Frequenzkonverters M2 verbunden ist. Alternativ kann auch hier wieder die Frequenz f"-$f_{ZF}$ bzw. f"+$f_{ZF}$ mittels einer PLL-Schaltung aus dem Spektrumanalysator SPA abgeleitet werden. Der Ausgang des Frequenzkonverters wird mit dem Eingang I2 der gewählten internen Zwischenfrequenzebene des Spektrumanalysators SPA verbunden. Im Gegensatz zur Anordnung von Fig. 4 die universell einsetzbar ist, setzt diese modifizierte Anordnung voraus, daß ein solcher Eingang existiert, was leider nicht bei allen handelsüblichen Geräten der Fall ist.

Bei dem erfindungsgemäßen Verfahren - gleich nach welcher der beiden beschriebenen Anordnungnen realisiert - erfolgt die eigentliche Auswertung der Spektrumanalyse mit dem Spektrumanalysator SPA. Auch die Bedienung erfolgt ganz wie in der Hochfrequenzmeßtechnik gewohnt am Spektrumanalysator. Das Meßergebnis erscheint auf dem Bildschirm des Spektrumanalysators SPA, nicht wie bei den Verfahren nach dem Stand der Technik auf dem des Elektronenstrahlmeßgerätes. Das Elektronenstrahlmeßgerät wird eigentlich nur zur Positionierung des Primärelektronenstrahls auf die Meßstelle benutzt. Dies erleichtert auch dem Nichtfachmann die Bedienung, denn eine spezielle Einarbeitung ist nicht erforderlich. Lediglich die Interpretation der erhaltenen Meßergebnisse weicht geringfügig von dem gewohnten Bild ab. Wegen der Mischbedingung (2) erscheint nämlich für jede Spektralkomponente im Signal u(t) am Meßort im gemessenen Spektrum ein Doppelpeak, wobei (in der Skala des Spektrumanalysators) der obere Peak der tatsächlichen Frequenz der gemessenen Spektralkomponente entspricht und der untere Peak genau um 2*$f_{ZF}$ darunterliegt. Fig. 6 verdeutlicht dies. In oberen Teil a) der Figur ist ein Spektrum des Signals an der Meßstelle dargestellt, im Teil b) das dazu mit dem erfindungsgemäßen Verfahren gemessene Spektrum. Es besteht aus zwei Peak-Paaren, die die beiden Spektrallinien des Meßsignals kennzeichnen.

Die ausschließliche Bedienung über den Spektrumanalysator SPA macht auch den Einsatz aller erweiterten Betriebsarten eines Spektrumanalysators möglich. Zu diesen erweiterten Betriebsarten zählen beispielsweise die automatische Peak-Erkennung, die Tracking-Betriebsart, in der der Analysator automatisch der Frequenzdrift einer Spektrallinie folgt, und die Monitoring-Betriebsart, in der der Analysator die zeitliche Änderung des Spektrums mißt und anzeigt.

Die erste Frequenzumsetzung ,(mit Hilfe des ersten Frequenzkonverters M1) muß nicht unbedingt um die Frequenz f-$f_{ZF}$ erfolgen, sondern es ist auch jede andere Frequenz möglich, solange nur dafür Sorge getragen wird, daß die zweite Frequenzkonversion in eine Eingangsfrequenzebene des Spektrumanalysaors SPA erfolgt (was bei der Realisierung nach Figur 5 beispielsweise automatisch der Fall ist). Dann kann auch eine Frequenzumsetzung um eine sehr hohe oder auch sehr niedrige Frequenz erfolgen. Im Extremfall ist sogar die Frequenz Null zulässig, d.h. die Frequenzkonversion kann vollständig entfallen. Der Generator G1 ist dann natürlich überflüssig und der erste Frequenzkonverter M1 kann als einfaches Verbindungsstück realisiert werden.

Mit einer weiteren Ausgestaltung des erfindungsgemäßen Verfahrens kann auch leicht die räumliche Verteilung einer Spektralkomponente gemessen werden. Dazu wird die Mittenfrequenz des Spektrumanalysators SPA auf die interessierende Signalfrequenz, deren örtliche Verteilung ermittelt werden soll, gesetzt und die "Zero-Span"-Betriebsart des Spektrumanalysators SPA gewählt. Der Spektrumanalysator SPA mißt dann die zeitliche Änderung dieser Spektrallinie. Sodann wird das demodulierte Ausgangssignal der letzten Stufe des Spektrumanalysators SPA (also das Signal das die y-Modulation der Spektrumanalysator-Bildröhre bewirkt) - es wird gewöhnlich als Video-Signal bezeichnet - gebenenfalls nach einer zusätzlichen Signalverarbeitung (z.B einer Pegelanpassung oder einem Vergleich mit einem Schwellwert zur Unterdrückung unerwünschter Störungen) dem z-Eingang (Helligkeitsmodulation) der Anzeige CRT des Elektronenstrahl-Meßgerätes zugeführt. In den Figuren 4 und 5 ist dies gestrichelt dargestellt. Wird nun der Primärelektronenstrahl PE (ganz analog wie beim herkömmlichen Frequency-Tracing-Verfahren) über die Probe IC und synchron dazu der Schreibstrahl über den Bildschirm CRT des Elektronenstrahlmeßgerätes gerastert, so erscheint auf dem Bildschirm die örtliche Verteilung der interessierenden Spektrallinie als Helligkeitsverteilung.

Mit einer weiteren Ausgestaltung des erfindungsgemäßen Verfahrens erhält man ein Ergebnis wie beim herkömmlichen Frequency-Mapping-Verfahren. Auch bei dieser Ausgestaltung wird das Video-Ausgangssignal des Spektrumanalysators SPA dem z-Eingang des Bildschirms CRT des Elektronenstrahlmeßgerätes verbunden. Allerdings wird der Spektrumanalysator SPA nicht in der "Zero-Span"-sondern in der herkömmlichen Wobbel-Betriebsart betrieben. Wie beim Frequency-Mapping-Verfahren läßt man den Primärelektronenstrahl PE nur entlang einer Linie rastern. Der Schreibstrahl des Bildschirms CRT rastert synchron dazu in einer Richtung beispielsweise in y-Richtung. Die Rasterung des Schreibstrahls in der dazu senkrechten Richtung, also der x-Richtung, muß nun synchron zum Wobbeldurchlauf des Spektrumanalysators SPA erfolgen. Dazu kann man entweder das Wobbelsignal des Spektrumanalysators SPA (häufig als "Sweepscan" bezeichnet), also das rampenförmige Signal, das die gerade analysierte Frequenz angibt, zur Ablenkung des Schreibstrahls benutzen oder auch umgekehrt die x-Ablenkspannung des Bildschirms CRT als externes Wobbelsignal dem Spektrumanalysator SPA zuführen.

Bislang war stets von einem Spektrumanalysator die Rede. Damit ist in diesem Zusammenhang ein Gerät zu verstehen, das eine Spektrumanalyse durchführt, und dazu den interessierenden Frequenzbereich durchwobbelt. Unter diese Definition fällt insbesondere auch ein sogenannter Network-Analyzer. Ein solches Gerät mißt nicht nur wie ein herkömmlicher Spektrumanalysator das Amplituden- sondern zusätzlich noch das Phasenspektrum. Ein solcher Network-Analyzer kann daher ebenfalls zur Realisierung des erfindungsgemäßen Verfahrens eingesetzt werden. Nach einer weiteren Ausgestaltung dieses Verfahren macht man von den erweiterten Möglichkeiten eines Network-Analyzers Gebrauch und mißt zusätzlich auch noch das Phasenspektrum des Signals u(t) am Meßort. Dazu ist es erforderlich, die Probenansteuerung mit dem Network-Ananlyzer zu synchronisieren. Dies kann beispielsweise über eine gemeinsame Referenzfrequenz erfolgen. Zusätzlich müssen auch bei den Frequenzkonversionen, die Phasenbeziehungnen der beteiligten Signale erhalten bleiben. Dies kann dadurch sichergestellt werden, daß man als Frequenzkonverter M1 und M2 Mischer einsetzt und dafür sorgt, daß die Ausgangssignale des ersten und gegebenenfalls auch des zweiten Signalgenerators G1 und G2 ebenfalls mit dem Network-Analyzer synchronisiert sind. Dies kann einfach erreicht werden, indem man diese Generatoren als PLL-Schaltungen auslegt, die ihr Ausgangssignal von einer Referenzfrequenz des Spektrumanalysators ableiten. Auf diese Art und Weise kann man Amplituden- und Phasenspektrum des Signals u(t) am Meßort gleichzeitig messen. Mit diesen beiden Informationen kann man dann sogar rechnerisch durch eine Fourier-Rücktransformation in den Zeitbereich den zeitlichen Verlauf des Signals u(t) am Meßort bestimmen.

Natürlich sind auch andere Ausführungsformen der Elektronenquelle ES als die in den Figuren 2-5 gezeigte möglich. So kann z.B. an Stelle der geheizten Kathode, die durch thermische Emission Primärelektronen PE erzeugt, eine Feldemissionskathode oder eine Photokathode, die durch Laserimpulse zur Aussendung von Elektronen angeregt wird, treten. Ebenso ist es möglich eine Halbleiterkathode zu verwenden. Bei einer Halbleiterkathode kann die Intensität der Emission sehr einfach durch Variation des Kathodenstroms erfolgen. Ein eigenständiges Strahlmodulationssystem hinter der Kathode kann dann entfallen, und das Modulationssignal MS steuert direkt den Kathodenstrom.

Neben dem in Zusammenhang mit Fig. 2-5 beschriebenen Sekundärelektronendetektor lassen sich selbstverständlich auch andere Detektoren zur Ableitung des sekundären Signals einsetzen. Beispiele dafür sind Szintillationszähler, Faraday-Käfige oder Halbleiterdetektoren. Dem Detektor selbst kann selbstverständlich stets auch eine Einrichtung zur Vervielfachung der Sekundärelektronen (wie z.B. eine Kanalplatte) vorgeschaltet sein. Im Prinzip kann jeder Detektor, der beim Auftreffen von Sekundärelektronen ein Meßsignal abgibt, Verwendung finden.

Zur Gewinnung des sekundären Signals SS kann insbesondere ein Energiespektrometer SP in die Anordnung eingebracht werden. Dies ist in den Figuren 2-5 durch ein Gegenfeldnetz angedeutet. Besonders gut eignet sich dazu ein Gegenfeldspektrometer, wie es beispielsweise aus der US-Patentschrift 4292419 bekannt ist. Wie ein solches Spektrometer zur Gewinnung eines Signals benutzt werden kann, ist dem Fachmann bekannt. Eine besonders einfache Möglichkeit ist z.B. das Anlegen einer konstanten Spannung an das Gegenfeldnetz.

Die Erfindung ist auch nicht so zu verstehen, daß der Primärstrahl PE fein fokussiert nur die Meßstelle bestrahlt, sondern ebenso ist es im Rahmen der Erfindung möglich, daß er die Probe großflächig bestrahlt und daß die Definition der Meßstelle erst durch eine ortsaufgelöste Gewinnung des sekundären Signals SS erfolgt. Ein Beispiel für eine solche Anwendung ist die Messung von Oberflächenpotentialen mit Photoelektronen mittels des Potentialkontrasts. Dazu kann die Probe auf ihrer ganzen Oberfläche mit Licht bestrahlt werden (der Primärstrahl PE ist also hier sehr stark aufgeweitet) und die entstehenden Photoelektronen SE können dann mit Hilfe eines Vielkanaldetektors nach ihrem Enstehungsort getrennt registriert und zu einem sekundären Signal umgeformt werden.

Die Mischung auf die Zwischenfrequenz $f_{ZF}$ beruht auf einem nichtlinearen Zusammenhang und der Modulation des Primärelektronenstrahles. Man kann dies aber auch erreichen, wenn man anstelle der Primärelektronen die Sekundärelektronen oder das sekundäre Signal (SS) in Ihrer Intensität moduliert. Dies ist beispielsweise möglich, indem man die Energieschwelle eines Gegenfeldspektrometers mit der Modulationsfrequenz $f_B$ moduliert Durch Berücksichtigung der Spektrometer-Kennlinie kann man sogar eine sinusförmige Modulation des Sekundärelektronen-Signals erreichen, und so eventuelle Schwierigkeiten mit Kreuzmodulationsprodukten, wie sie beim beschriebenen Verfahren unter Umständen auftreten können, vermeiden. Durch die höheren umzuladenden Kapazitäten und die Energiedispersion der Sekundärelektronen ist allerdings die Grenzfrequenz geringer. Außerdem wird durch das Spektrometer das Gesichtsfeld eingeschränkt. Analog kann man auch den Photomultiplier zusammen mit einer Gate-Schaltung betreiben oder im Video-Signalpfad modulieren. In diesem Fall ist die erreichbare Bandbreite indes niedriger.

Die Erfindung wurde bisher anhand des Potentialkontrasteffekts in einem Elektronenstrahlmeßgerät beschrieben. Ihre Anwendung ist aber keinesfalls darauf beschränkt. Anstelle der Primär-und Sekundärelektronen können auch beliebige andere Korpuskel, wie z.B. Ionen, oder eine beliebiege Strahlung, insbesondere Lichtstrahlung treten. Verwendet man beispielsweise als Primärstrahl PE einen Laserstrahl, so kann dieser auf der Probenoberfläche Photoelektronen auslösen, die dann aufgrund des Potentialkontrasts von den elektrischen Feldern an der Probenoberfläche beeinflußt werden und, wie zuvor beschrieben, als Sekundärelektronen detektiert werden können. Aber auch andere Wechselwirkungen können anstelle des Potentialkontrasts treten. Dazu zählt beispielsweise die Beeinflussung der von einem Primärelektronenstrahl PE erzeugten Sekundärelektronen SE durch ein magnetisches Feld. Durch Ausnutzung dieses sogenannten "magnetischen Kontrasts" ließe sich etwa die Bewegung magnetischer Domänen in Magnetblasenspeichern untersuchen. Auch braucht das sekundäre Signal SS-keineswegs von einem Sekundäkorpuskelstrom herzurühren, der mit Hilfe eines Detektors registriert wird. Ebenso ist es beispielsweise möglich, das sekundäre Signal direkt von der Probe abzuleiten, indem man z.B. den vom Primärstrahl PE in der Probe IC induzierten Strom mißt. Ein Beispiel für eine solche Technik, ist die dem Fachmann wohlbekannte EBIC (Electron beam induced current)-Technik.

Selbstverständlich kann man die verschiedenen Abwandlungen auch kombiniert einsetzen. Verwendet man wiederum einen Laserstrahl als Primärstrahl PE und eine integrierte Schaltung als Probe IC, so kann der Laserstrahl in den pn-Übergängen der Probe IC Elektron-Loch-Paare und damit freie Ladungsträger erzeugen. Dies macht sich dann in einer Änderung der Stromaufnahme der Probe IC bemerkbar. Wie groß diese Änderung ist, hängt auch vom Schaltzustand des jeweiligen pn-Übergangs ab. Eine Änderung des Schaltzustands eines pn-Übergangs ließe sich deshalb leicht durch eine Messung des Versorgungsstroms der Probe IC feststellen. Der Versorgungsstrom der Probe bzw. seine Abweichung vom Ruhestrom kann in diesem Fall unmittelbar als sekundäres Signal SS dienen, ein besonderer Detektor ist nicht erforderlich. Ebenso ist es möglich einen Laserstrahl als Primärstrahl zu benutzen, um das Oberflächenpotential der Probe IC zu messen. Die Wechselwirkung, die den multiplikativen Zusammenhang zur Verfügung stellt, sind in diesem Fall elektrooptische Effekte. Man bringt dazu einen elektrooptischen Kristall auf die Probenoberfläche auf. Zur Gewinnung des sekundären Signals könnte der Primärstrahl PE auf den elektrooptischen Kristall gerichtet und das reflektierte Licht über einen Polarisator geleitet und einem Detektor, beispielsweise einem Photomultiplier, zugeführt werden. Wenn der elektrooptische Kristall in Abhängigkeit vom Oberflächenpotential der Probe die Polarisationsebene des Lichts dreht, liefert der Photomultiplier an seinem Ausgang ein Signal, dessen Signalhöhe vom Oberflächenpotential der Probe abhängt und daher als sekundäres Signal benutzt werden kann.

### Patentansprüche

1.  Verfahren zur schnellen Durchführung einer Spektrumanalyse eines wiederkehrenden Signals (u(t)) an wenigstens einem Meßpunkt einer Probe (IC) und/oder zur Messung der örtlichen Verteilung einer einzelnen Spektralkomponente
    bei dem:
    - die Probe (IC) mit einem Primärstrahl (PE) beaufschlagt wird,
    - eine Wechselwirkung zwischen dem Primärstrahl (PE) und der Probe (IC) besteht,
    - von der Probe ein sekundäres Signal (SS) abgeleitet wird, das von der Wechselwirkung zwischen Primärstrahl und Probe beeinflußt wird,
    - bei dem der Primärstrahl (PE) oder die Sekundärstrahlung bzw. der Strom der Sekundärkorpuskel (SE) oder eine Einrichtung zur Gewinnung oder Verarbeitung des sekundären Signals (SS) mit einer Modulationsfrequenz ($f_B$) moduliert wird,
    - bei dem durch diese Modulation und durch die Wechselwirkung eine bestimmte Frequenzkomponente ($f_B$) des wiederkehrenden Signals (u(t)) im sekundären Signal (SS) auf eine Zwischenfrequenz ($f_{ZF}$) gemischt wird, dadurch gekennzeichnet, daß die Modulationsfrequenz ($f_B$) durch eine erste Frequenzkonversion aus einem Lokaloszillatorsignal eines Spektrumanalysators (SPA) gewonnen wird, und daß die Signalkomponente des sekundären Signals bei der Zwischenfrequenz ($f_{ZF}$) durch eine zweite Frequenzkonversion in eine Eingangsfrequenzebene des Spektrumanalysators transformiert wird.

2.  Verfahren nach Anspruch 1,
    dadurch gekennzeichnet, daß es sich bei der Eingangsfrequenzebene des Spektrumanalysators (SPA) um dessen Eingangsselektionsebene handelt.

3.  Verfahren nach Anspruch 1,
    dadurch gekennzeichnet, daß es sich bei der Eingangsfrequenzebene des Spektrumanalysators (SPA) um eine interne Zwischenfrequenzebene (f") des Spektrumanalysators (SPA) handelt.

4. Verfahren nach einem der Ansprüche 1 bis 3,
dadurch gekennzeichnet, daß der Spektrumanalysator im Wobbelbetrieb betrieben wird.

5. Verfahren nach einem der Ansprüche 1 bis 4, dadurch gekennzeichnet,
   - daß der Spektrumanalysator (SPA) im "Zero Span"-Modus betrieben wird,
   - daß das Ausgangssignal des Spektrumanalysators (SPA) einer Aufzeichnungseinrichtung (CRT) zugeführt wird,
   - daß der Aufzeichnungseinrichtung (CRT) zusätzlich wenigstens ein Signal, das eine Ortsinformationen über den jeweiligen Meßpunkt trägt, zugeführt wird,
   - daß der Primärstrahl nacheinander auf die verschiedenen Meßpunkte positioniert wird.

6. Verfahren nach einem der Ansprüche 1 bis 5,
dadurch gekennzeichnet, daß es sich bei der Wechselwirkung zwischen dem Primärstrahl und der Probe um die Erzeugung von Sekundärelektronen (SE) durch den Primärstrahl (PE) und die nachfolgende Beeinflussung der Sekundärelektronen durch den Potentialkontrast handelt.

7. Anordnung zur schnellen Durchführung einer Spektrumanalyse eines wiederkehrenden Signals (u(t)) an wenigstens einem Meßpunkt einer Probe (IC) und/oder zur Messung der örtlichen Verteilung einer einzelnen Spektralkomponente mit folgenden Merkmalen:
   - die Anordnung enthält eine Primärstrahlquelle (ES) zur Erzeugung eines Primärstrahls,
   - die Anordnung enthält eine Vorrichtung zur Führung und Fokussierung des Primärstrahls (PE) auf die Probe (IC), die von einer Ansteuerung (ICA) mit Versorgungsspannungen und/oder Ansteuersignalen versorgt wird,
   - die Anordnung enthält eine Vorrichtung (DT, PA) zur Ableitung eines sekundären Signals (SS) von der Probe (IC), wobei dieses sekundäre Signal (SS) von einer Wechselwirkung zwischen dem Primärstrahl (PE) und der Probe (IC) beeinflußt wird,
   - die Anordnung enthält eine Vorrichtung (BBS) zur Modulation des Primärstrahls (PE) oder der Sekundärstrahlung bzw. des Stroms der Sekundärkorpuskel (SE) oder einer Einrichtung zur Gewinnung oder Verarbeitung des sekundären Signals (SS) mit einer Modulationsfrequenz ($f_B$),
   - die Anordnung enthält einen Spektrumanalysator (SPA), gekennzeichnet durch die folgenden weiteren Merkmale :
   - die Anordnung enthält einen ersten Frequenzkonverter (M1), dessen erster Eingang mit einem Lokaloszillator-Ausgang des Spektrumanalysators (SPA) verbunden ist und dessen Ausgang mit der Vorrichtung (BBS) zur Modulation verbunden ist,
   - die Anordnung enthält einen zweiten Frequenzkonverter (M2), dessen erster Eingang mit der Einrichtung (DT, PA) zur Ableitung des sekundären Signal (SS) und dessen Ausgang mit einem Eingang des Spektrumanalysators (SPA) verbunden ist.

8. Anordnung nach Anspruch 7,
dadurch gekennzeichnet, daß die Primärstrahlquelle (ES) aus einer Elektronenkanone (EG) zur Erzeugung eines unmodulierten Stroms von Primärkorpuskeln (PE) und einem nachgeschalteten Strahlmodulationsystem (BBS) als Vorrichtung zur Modulation besteht.

9. Anordnung nach einem der Ansprüche 7 oder 8,
gekennzeichnet durch einen Strahlmodulationsgenerator (BBG), der der Vorrichtung zur Modulation (BBS) über einen Modulationseingang (MI) ein Modulationssignal zuführt, durch das eine Modulation des Primärstrahls (PE) oder der Sekundärstrahlung bzw. des Stroms der Sekundärkorpuskel (SE) oder einer Einrichtung zur Gewinnung oder Verarbeitung des sekundären Signals (SS) bewirkt wird, wobei der Eingang des Strahlmodulationsgenerators mit dem Ausgang des ersten Frequenzkonverters verbunden ist.

10. Anordnung nach einem der Ansprüche 7 bis 9,
dadurch gekennzeichnet, daß die Ausgangsfrequenz des ersten Frequenzkonverters (M1) nur um einen konstanten Frequenzwert ($f_{ZF}$) von dem Absolutbetrag der Differenz der Frequenz des Signals am Lokaloszillator-Ausgang ($f_{LO}$) und der Frequenz einer ersten internen Zwischenfrequenz (f') des Spektrumanalysator (SPA) abweicht, wobei dieser konstante Frequenzwert ($f_{ZF}$) kleiner ist als die obere Grenzfrequenz der Vorrichtung (DT, PA) zur Ableitung des sekundären Signals (SS).

11. Anordnung nach einem der Ansprüche 7 bis 10,
dadurch gekennzeichnet, daß der Ausgang des zweiten Frequenzkonverters (M2) mit dem Selektionseingang des Spektrumanalysators (SPA) verbunden ist und der zweite Frequenzkonverter (M2) eine Frequenztransformation um den Wert der Modulationsfrequenz ($f_B$) vornimmt.

12. Anordnung nach einem der Ansprüche 7 bis 10,
dadurch gekennzeichnet, daß der Ausgang des zweiten Frequenzkonverters (M2) mit einem Eingang zu einer internen Zwischenfrequenz-Stufe des Spektrumanalysators (SPA) verbunden ist und der zweite Frequenzkonverter (M2) eine Frequenztransformation um den Absolutbetrag der Differenz oder Summe der Zwischenfrequenz (f") der internen Zwischenfrequenz-Stufe und des konstanten Frequenzwertes ($f_{ZF}$) vornimmt.

13. Anordnung nach einem der Ansprüche 7 bis 12,
dadurch gekennzeichnet, daß ein Ausgang des Spektrumanalysator mit einem Eingang einer Aufzeichnungseinrichtung (CRT) verbunden ist, wobei der Aufzeichnungseinrichtung (CRT) wenigstens ein weiteres Signal zugeführt wird, das Informationen über den Ort des jeweiligen Meßpunkts trägt.

14. Anordnung nach einem der Ansprüche 7 bis 13,
dadurch gekennzeichnet, daß es sich bei der Aufzeichnungseinrichtung um einen Bildschirm handelt und daß das Wobbeln des Spektrumanalysators (SPA) mit der Ablenkung des Schreibstrahls der Aufzeichnungseinrichtung synchronisiert erfolgt.


## Claims

1. Process for rapid spectral analysis of a recurrent signal (u(t)) on at least one measuring point of a sample (IC) and/or for measuring the local distribution of an individual spectral component,
wherein:
   - the sample (IC) is irradiated by a primary beam (PE),
   - an interaction is established between said primary beam (PE) and said sample (IC),
   - a secondary signal (SS) is derived from said sample, which is influenced by the interaction between said primary beam and said sample,
   - wherein said primary bean (PE) or said secondary radiation or the current of secondary corpuscles (SE) or a means for producing or processing said secondary signal (SS) is modulated with a modulation frequency ($f_B$),
   - wherein a certain frequency component ($f_B$) of said recurrent signal (u(t)) is mixed by this modulation and by said interaction in the secondary signal (SS) to an intermediate frequency ($f_{ZF}$),
   **characterized** in that said modulation frequency ($f_B$) is produced by a first frequency conversion from a local oscillator signal of a spectrum analyzer (SPA), and that said signal component of said secondary signal at said intermediate frequency ($f_{ZF}$) is transformed by a second frequency conversion into an input frequency level of said spectrum analyzer.

2. Process according to Claim 1,
**characterized** in that said input frequency level of said spectrum analyzer (SPA) is the latter's input selection level.

3. Process according to Claim 1,
**characterized** in that said input frequency level of said spectrum analyzer (SPA) is an internal intermediate frequency level (f") of said spectrum analyzer (SPA).

4. Process according to any of the Claims 1 to 3,
**characterized** in that said spectrum analyzer is operated in the wobbulating mode.

5. Process according to any of the Claims 1 to 4,
**characterized** in that
   - said spectrum analyzer (SPA) is operated in the "zero-span" mode,
   - that said output signal of said spectrum analyzer (SPA) is supplied to a recording means (CRT),
   - that said additionally at least one signal, which carries a local information about the respective measuring point, is supplied to said recording means (CRT),

- that said primary beam is successively positioned to the various measuring points.

6. Process according to any of the Claims 1 to 5,
**characterized** in that said interaction between said primary beam and said sample involves the generation of secondary electrons (SE) by said primary beam (PE) and the subsequent influence of said potential contrast on said secondary electrons.

7. System for rapid spectral analysis of a recurrent signal (u(t)) on at least one measuring point of a sample (IC) and/or for measuring the local distribution of an individual spectral component, comprising the following features:
   - the system includes a primary beam sources (ES) for generating a primary beam,
   - the system includes a device for guiding and focusing the primary beam (PE) onto said sample (IC) which is supplied by a controller (ICA) with supply voltages and/or control signals,
   - the system comprises a device (DT, PA) for deriving a secondary signal (SS) from said sample (IC), which secondary signal (SS) is influenced by an interaction between said primary beam (PE) and said sample (IC),
   - the system comprises a device (BBS) for modulating said primary beam (PE) or said secondary beam or current of secondary corpuscles (SE), respectively, or a means for producing or processing said secondary signal (SS) with a modulation frequency ($f_B$),
   - the system comprises a spectrum analyzer (SPA),
   **characterized** in that
   - said system includes a first frequency converter (M1) whose first input is connected to a local oscillator output of said spectrum analyzer (SPA) and whose output is connected to said modulating device (BBS),
   - that the system comprises a second frequency converter (M2) whose first input is connected to said device (DT, PA) for deriving said secondary signal (SS) and whose output is connected to an input of said spectrum analyzer (SPA).

8. System according to Claim 7,
**characterized** in that said primary beam source (ES) consists of an electron gun (EG) for generating an unmodulated current of primary corpuscles (PE) and of a joining beam modulation system (BBS) as modulating device.

9. System according to any one of Claims 7 or 8,
**characterized** by a beam modulation generator (BBG) which supplies to said modulating device (BBS) a modulation signal via a modulation input (MI), which signal causes a modulation of said primary beam (PE) or said secondary radiation or said current of secondary corpuscles (SE), respectively, or a means for generating or processing said secondary signal (SS), with the input of said beam modulation generator being connected to the out put of said first frequency converter.

10. System according to any one of Claims 7 to 9,
**characterized** in that the output frequency of said first frequency converter (M1) varies from an absolute amount of the difference of the frequency of the signal at the local oscillator output ($f_{LO}$) and the frequency of a first internal intermediate frequency (f') of said spectrum analyzer (SPA) by a constant frequency value ($f_{ZF}$) only, with said constant frequency value ($f_{ZF}$) being smaller than the upper limit frequency of said device (DT, PA) for deriving said secondary signal (SS).

11. System according to any one of Claims 7 to 10,
**characterized** in that the output of said second frequency converter (SPA) is connected to the selection input of said spectrum analyzer (SPA) and that said second frequency converter (M2) carries out a frequency transformation by the value of said modulation frequency ($f_B$).

12. System according to any one of Claims 7 or 8,
**characterized** in that the output of said second frequency converter (M2) is connected to an input to an internal intermediate-frequency stage of said spectrum analyzer (SPA) and that said second frequency converter (M2) performs a frequency transformation by the absolute amount of the difference or the total of said intermediate frequency (f") of said internal intermediate-frequency stage and said constant frequency value ($f_{ZF}$).

13. System according to any one of Claims 7 to 12,
**characterized** in that one output of said spectrum analyzer is connected to an input of a recording means (CRT), with said recording means (CRT) being supplied with at least one further signal carrying information about the location of the respective measuring point.

14. System according to any one of Claims 7 to 13,
**characterized** in that said recording means is a screen and that the wobbulation of said spectrum analyzer (SPA) takes place in synchrony with the deflection of the recording beam of said recording means.

## Revendications

1. Procédé d'analyse spectrale rapide de signaux récurrents (u(t)) en au moins un point de mesure d'une éprouvette (IC) et/ou pour mesurer la distribution locale d'un composant spectral individuel, dans lequel:
   - l'éprouvette (IC) est exposée à un faisceau primaire (PE),
   - on établit une interaction entre ledit faisceau primaire (PE) et ladite éprouvette (IC),
   - on dérive un signal secondaire (SS) de ladite éprouvette, qui est exposé à l'influence par l'interaction entre ledit faisceau primaire et ladite éprouvette,
   - dans lequel le faisceau primaire (PE) ou le rayonnement secondaire ou le courant des corpuscules secondaires ou des moyens pour engendrer ou traiter ledit signal secondaire (SS) est modulé par une fréquence de modulation ($f_B$),
   - dans lequel un certain composant de fréquence ($f_B$) dudit signal récurrant (u(t)) est mélangé par cette modulation et par l'interaction dans le signal secondaire (SS) à une fréquence intermédiaire ($f_{ZF}$),
   **caractérisé** en ce que ladite fréquence de modulation ($f_B$) et engendrée par une première transformation de fréquence d'un signal d'oscillateur local d'un analyseur spectral (SPA), et en ce que ledit composant de signal dudit signal secondaire à ladite fréquence intermédiaire ($f_{ZF}$) est transformé par une deuxième transformation de fréquence dans un niveau de fréquence d'entrée dudit analyseur spectral.

2. Procédé selon la revendication 1,
**caractérisé** en ce que ledit niveau de fréquence d'entrée dudit analyseur spectral (SPA) est le niveau de sélection d'entrée du dernier.

3. Procédé selon la revendication 1,
**caractérisé** en ce que ledit niveau de fréquence d'entrée dudit analyseur spectral (SPA) est un niveau de fréquence intérieure intermédiaire (f") dudit analyseur spectral (SPA).

4. Procédé selon une quelconque des revendications 1 à 3,
**caractérisé** en ce que ledit analyseur spectral est agencé dans le mode de vobulation.

5. Procédé selon une quelconque des revendications 1 à 4,
**caractérisé** en ce que
   - ledit analyseur spectral (SPA) est agencé dans le mode "zéro-span",
   - que ledit signal de sortie dudit analyseur spectral (SPA) est alimenté à des moyens d'enregistrement (CRT),
   - que de plus au moins un signal, qui portent une information locale sur le point de mesure respectif, est alimenté auxdits moyens d'enregistrement (CRT),
   - que ledit faisceau primaire est positionné en succession sur les plusieurs points de mesure.

6. Procédé selon une quelconque des revendications 1 à 5,
**caractérisé** en ce que ladite interaction entre ledit faisceau primaire et ladite éprouvette est la génération d'électrons secondaires (SE) par ledit faisceau primaire (PE) et l'influence suivante dudit contraste de potentiel sur lesdits électrons secondaires.

7. Système d'analyse spectrale rapide de signaux récurrents (u(t)) en au moins un point de mesure d'une éprouvette (IC) et/ou pour mesurer la distribution locale d'un composant spectral individuel, comprenant les caractéristiques suivantes;
   - le système comprend une source de faisceau primaire (ES) pour engendrer un faisceau primaire,
   - le système comprend un dispositif pour guider et focaliser ledit faisceau primaire (PE) sur ladite éprouvette (IC), laquelle est alimentée en des tensions d'alimentation et/ou des signaux de commande par un contrôleur (ICA),
- le système comprend un dispositif (DT, PA) pour dériver un signal secondaire (SS) de ladite éprouvette (IC), lequel signal secondaire (SS) est influencé par une interaction entre ledit faisceau primaire (PE) et ladite éprouvette (IC),
- le système comprend un dispositif (BBS) pour moduler ledit faisceau primaire (PE) ou dudit faisceau secondaire ou respectivement le courant des corpuscules secondaires (SE), ou des moyens pour engendrer ou traiter ledit signal secondaire (SS) par une fréquence de modulation ($f_B$),
- le système comprend un analyseur spectral (SPA),

**caractérisé** en ce que
- ledit système comprend un premier transformateur de fréquence (M1) dont la première entrée est raccordé à la sortie d'oscillateur local dudit analyseur spectral (SPA) et dont la sortie est raccordée auxdits moyens de modulation (BBS),
- en ce que le système comprend un deuxième transformateur de fréquence (M2) dont la première entrée est raccordée auxdits moyens (DT, PA) pour dériver ledit signal secondaire (SS), et dont la sortie est raccordée à une entrée dudit analyseur spectral (SPA).

8. Système selon la revendication 7,
**caractérisé** en ce que ladite source de faisceau primaire (ES) est composée d'un canon cathodique (EG) pour engendrer un courant non-modulé de corpuscules primaires (PE), ainsi que d'un système suivant de modulation de faisceau (BBS) en tant que modulateur.

9. Système selon une quelconque des revendications 7 ou 8,
**caractérisé** par un générateur de modulation de faisceau (BBG) qui alimente ledit dispositif de modulation (BBS) en un signal de modulation par une entrée de modulation (MI), lequel signal déclenche une modulation dudit faisceau primaire (PE) ou dudit rayonnement secondaire ou respectivement dudit courant de corpuscules secondaires (SE), ou des moyens pour engendrer ou traiter ledit signal secondaire (SS), ladite entrée dudit générateur de modulation de faisceau étant raccordée à la sortie dudit premier transformateur de fréquence.

10. Système selon une quelconque des revendications 7 à 9,
**caractérisé** en ce que la fréquence de sortie dudit premier transformateur de fréquence (M1) ne dévie d'un montant absolu de la différence entre la fréquence du signal à la sortie de l'oscillateur local ($f_{LO}$) et la fréquence d'une première fréquence intérieure intermédiaire (f') dudit analyseur spectral (SPA) que par une valeur de fréquence constante ($f_{ZF}$), ladite valeur de fréquence constante ($f_{ZF}$) étant inférieure à la fréquence limite supérieure dudit dispositif (DT, PA) pour dériver ledit signal secondaire (SS).

11. Système selon une quelconque des revendications 7 à 10,
**caractérisé** en ce que la sortie dudit deuxième transformateur de fréquence (SPA) est raccordée à l'entrée de sélection dudit analyseur spectral (SPA), et en ce que ledit deuxième transformateur de fréquence (M2) réalise une transformation de fréquence par la valeur de ladite fréquence de modulation ($f_B$).

12. Système selon une quelconque des revendications 7 ou 8,
**caractérisé** en ce que la sortie dudit deuxième transformateur de fréquence (M2) est raccordée à une entrée dans une étage intérieure à fréquence intermédiaire dudit analyseur spectral (SPA), et en ce que ledit transformateur de fréquence (M2) réalise une transformation de fréquence par le montant absolu de la difféöence ou le total de ladite fréquence intermédiaire (f") de ladite étage intérieure à fréquence intermédiaire et ladite valeur de fréquence constante ($f_{ZF}$).

13. Système selon une quelconque des revendications 7 à 12,
**caractérisé** en ce qu'une sortie dudit analyseur spectral est raccordée à une entrée de moyens d'enregistrement (CRT),j lesdits moyens d'enregistrement (CRT) étant alimentés en au moins un signal additionnel, qui porte des informations sur l'endroit du point de mesure respectif.

14. Système selon une quelconque des revendications 7 à 13,
**caractérisé** en ce que lesdits moyens d'enregistrement sont constitués par un écran, et en ce que la vobulation dudit analyseur spectral (SPA) se fait en synchronisation au balayage du faisceau d'enregistrement desdits moyens d'enregistrement.

$i_{PE}(t)$

$f_B$

$i_{SE}(t)$

$f_{ZF} = \left| n \cdot f_B - m \cdot f_S \right|$

$f_S \quad u(t)$

IC

Fig. 1

EP 0 428 663 B1

a

$f_S$          f

$2 \cdot f_{ZF}$

$2 \cdot f_{ZF}$

b

$f_S$          f

Fig. 6

EP 0 428 663 B1

BBG

MI

EG

ES

BBS

PE

$f_B$

$f_B$

SE

$f_{ZF}$

DT

PM

PA

BP

AMD

CM

SS

$f_{ZF}$

TH

z

CRT

ICA

IC

Fig. 2

Fig. 3

Fig. 4

EP 0 428 663 B1

EP 0 428 663 B1

ES

EG

BBS MI

$f_B$

BBG $f_B$ M1 $f_B$ $f' - f_{ZF}$ G1

$f_{LO}$

PE

LO Video z CRT

SPA

$f_B$ DT PA M2 f"

SE PM SS I2

$f_{ZF}$

SP

ICA IC G2 $f" \pm f_{ZF}$

Fig. 5